# EUROPEAN PATENT APPLICATION

(11) **EP 2 157 782 A2**
(43) Date of publication of application: **24.02.2010**
(21) Application number: 09009098.6
(22) Date of filing: 13.07.2009
(51) Int. Cl.: H04N 5/225, G02B 3/00

(54) **Stacked type camera module, method of manufacturing stacked type camera module, and imaging apparatus**

(30) Priority: 21.08.2008 JP 2008212535
(71) Applicant: Fujinon Corporation, Saitama-shi, Saitama (JP)
(72) Inventor: Yoneyama, Kazuya, Saitama-shi Saitama (JP)
(74) Representative: Metzler, Volker

(57) **Abstract**

Disclosed is a stacked type camera module capable of improving image quality while preventing an increase in manufacturing costs.

A stacked type camera module includes lens substrates having lenses respectively provided thereon, an imaging substrate having an imaging device with a light receiving surface provided thereon, and a position adjusting substrate having an actuator for adjusting the positional relationship between the substrates provided thereon. The substrates are stacked such that the imaging device can capture the optical image of an object formed on the light receiving surface through the lenses.

## Description

### BACKGROUND OF THE INVENTION

### 1. Field of the Invention

The present invention relates to a stacked type camera module that captures the optical image of an object, a method of manufacturing the stacked type camera module, and an imaging apparatus.

### 2. Description of the Related Art

In recent years, the size and cost of a camera module provided in, particularly, a mobile phone have been reduced.

A technique called a wafer-level optical system or a wafer-level camera has been developed in order to reduce the size of a camera module (see Wafer-Level Camera Technology. Copyright 2008 Tessera, Inc. All rights reserved. [retrieved on 2008-05-20]. Retrieved from the Internet: <URL:
http://www.tessera.com/technologies/products/wafer_level_c amera/>). In this technique, a semiconductor process is used to arrange small lenses in a matrix on a glass substrate, thereby forming a lens array, and a necessary number of the same type of glass substrates are stacked to each other. Then, the stacked structure is cut into individual lens systems in a direction in which the substrates are stacked, thereby obtaining imaging lenses. In addition, a technique has been proposed which uses a semiconductor process to manufacture a lens for an optical disk (see JP-A-2000-131508).

Since there is no movable part in the wafer-level camera, the wafer-level camera is solid and can be mounted to a printed circuit board by a reflow mounting method.
In addition, the wafer-level camera has high mass productivity and low manufacturing costs. Further, in the wafer-level camera, it is not necessary to perform focus adjustment during the assembly between an imaging lens and an imaging device.

Further, a camera module has been proposed which can be mounted by a reflow mounting method and uses an optical system having high heat resistance (see Japanese Patent No. 3976780, Japanese Patent No. 3976781, and Japanese Patent No. 3976782). This technique bonds a thermosetting resin to a glass substrate to form a lens, thereby obtaining an imaging lens having high heat resistance.

However, it is necessary to further increase the performance of the wafer-level camera, which is a stacked type camera module having high mass productivity. For example, the same performance as that of a digital camera with an auto focus mechanism is required.

The wafer-level camera is designed to have such a large focal depth that an auto focus mechanism, that is, a movable portion is not required. Therefore, in the wafer-level camera, the sharpness of an optical image formed on a light receiving surface is likely to be lowered, as compared to a structure including the auto focus mechanism. That is, the wafer-level camera is advantageous in that, even when a distance to an object varies, the sharpness of an optical image formed on the light receiving surface does not greatly deteriorate since the wafer-level camera has a large focal depth. However, the wafer-level camera has a problem in that it is difficult to form an optical image with high sharpness on the light receiving surface in the focal depth range all the time. The problem is not limited to the wafer-level camera, but generally arises in cameras without a focusing mechanism.

For example, when a focusing mechanism used for a general digital camera is applied to the wafer-level camera, the size of an apparatus increases, and it is difficult to stack members to manufacture an apparatus, which results in a reduction in mass productivity and an increase in manufacturing costs.

### SUMMARY OF THE INVENTION

The invention has been made in order to solve the above-mentioned problems, and an object of the invention is to provide a stacked type camera module capable of improving image quality while preventing an increase in manufacturing costs, a method of manufacturing the stacked type camera module, and an imaging apparatus.

According to an aspect of the invention, there is provided a method of manufacturing a stacked type camera module. The method includes: stacking one or more lens substrates, each having lenses provided in a plurality of predetermined regions, an imaging substrate having imaging devices, each having a light receiving surface, provided at positions corresponding to the regions, and one or more position adjusting substrates having actuators that adjust the positional relationship between the substrates and are provided at positions corresponding to the regions, such that an optical image of an object is formed on the light receiving surfaces through the lenses; and cutting the stacked structure into parts corresponding to the regions along a plane of the stacked structure that is orthogonal to a direction in which the substrates are stacked, thereby obtaining a plurality of stacked type camera modules each having the imaging device capable of capturing the optical image formed on the light receiving surface.

According to another aspect of the invention, a stacked type camera module includes: one or more lens substrates having lenses provided thereon; an imaging substrate having an imaging device with a light receiving surface provided thereon; and one or more position adjusting substrates having actuators for adjusting the positional relationship between the substrates provided thereon. The substrates are stacked such that an optical image of an object is formed on the light receiving surface of the imaging device through the lenses.

The term 'between the substrates' means between two lens substrates among a plurality of lens substrates or between the lens substrate and the imaging substrate.

The term 'stack' is not limited to stacking adjacent substrates, but includes stacking two substrates with another component interposed therebetween.

In addition, 'the substrates are stacked such that the imaging device can capture the optical image of an object formed on the light receiving surface through the lenses' means that one or more lens substrates, the imaging substrate, and one or more position adjusting substrates are stacked such that the imaging device can capture the optical image of an object formed on the light receiving surface through the lenses.

The position adjusting substrate may adjust the positional relationship between adjacent substrates in a direction in which the substrates are stacked. The position adjusting substrate may adjust the positional relationship between adjacent substrates in a direction orthogonal to the direction in which the substrates are stacked. The position adjusting substrate may adjust the inclination between adjacent substrates.

In the stacked type camera module according to the above-mentioned aspect, two or more lens substrates may be provided, and the position adjusting substrates may be provided both between the imaging substrate and the lens substrate adjacent to each other and between adjacent lens substrates.

The stacked type camera module according to the above-mentioned aspect may further include: a base substrate that is provided on one side of the imaging substrate opposite to the lens substrate; and a base position adjusting substrate which is provided between the base substrate and the imaging substrate and on which an actuator for adjusting the positional relationship between the substrates in a direction orthogonal to the direction in which the substrates are stacked is provided.

The actuator may be a piezoelectric element.

The actuator may be arranged outside an optical path having a cylindrical shape that extends in the direction in which the substrates for transmitting the optical image of the object to the light receiving surface are stacked.

According to still another aspect of the invention, an imaging apparatus includes the above-mentioned stacked type camera module.

According to the stacked type camera module, the method of manufacturing the stacked type camera module, and the imaging apparatus of the above-mentioned aspects of the invention, a position adjusting substrate having an actuator for adjusting the positional relationship between the substrates formed thereon is provided. Therefore, it is possible to perform focusing to accurately form the optical image of an object on the light receiving surface of the imaging device. In addition, since the position adjusting substrate can also be stacked similar to the other lens substrates, it is easy to assemble a camera module, and it is possible to improve image quality while preventing an increase in manufacturing costs.

That is, when a focusing mechanism is not provided, it is necessary to adopt an optical system capable of forming an optical image that has low sharpness and a large focal depth on the light receiving surface of the imaging device. When focusing is performed, it is possible to adopt an optical system capable of forming an optical image that has a small focal depth and high sharpness on the light receiving surface. In this way, it is possible to improve image quality.

The position adjusting substrate adjusts the positional relationship between adjacent substrates in a direction in which the substrates are stacked. According to this structure, it is possible to accurately form the optical image of an object on the light receiving surface.

In this case, the position adjusting substrate is provided between the imaging substrate and the lens substrate adjacent to each other to increase or decrease the gap between the substrates in the direction in which the substrates are stacked. In this way, it is possible to move the entire lens system relative to the imaging device to adjust focusing. As a result, it is possible to achieve auto focusing with a very small structure.

The position adjusting substrate adjusts the positional relationship between adjacent substrates in a direction orthogonal to the direction in which the substrates are stacked. According to this structure, it is possible to correct camera shake. In this case, when a photographer uses a low shutter speed to take a photograph (under low illumination conditions), it is possible to prevent image shake due to camera shake. Specifically, it is possible to move a specific lens of a lens system in a direction in which the camera shake is removed.

The position adjusting substrate adjusts the inclination between adjacent substrates. According to this structure, it is possible to correct the camera shake or aberration occurring in the optical image formed on the light receiving surface.

The stacked type camera module includes two or more lens substrates, and the position adjusting substrates are provided both between the imaging substrate and the lens substrate adjacent to each other and between adjacent lens substrates. According to this structure, it is possible to obtain a so-called floating focus effect that individually moves the lenses in the entire lens system that is moved to perform focusing to correct a variation in imaging position, which is a problem in close-up photography.

The stacked type camera module according to the above-mentioned aspect further includes: a base substrate that is provided on one side of the imaging substrate opposite to the lens substrate; and a base position adjusting substrate which is provided between the base substrate and the imaging substrate and on which an actuator for adjusting the positional relationship between the substrates in a direction orthogonal to the direction in which the substrates are stacked is provided.
According to this structure, it is possible to correct camera shake. In this case, when a photographer uses a low shutter speed to take a photograph (under low illumination conditions), it is possible to prevent image shake due to camera shake. Specifically, it is possible to move the entire camera in a direction in which the camera shake is removed.

The actuator is a piezoelectric element. According to this structure, it is possible to reliably adjust the positional relationship between the substrates.

The actuator has a cylindrical shape with an opening that extends in the direction in which the substrates for transmitting the optical image of the object to the light receiving surface are stacked. According to this structure, it is possible to reliably adjust the positional relationship between the substrates.

### BRIEF DESCRIPTION OF THE DRAWINGS

Fig. 1 is a cross-sectional view schematically illustrating the structure of a stacked type camera module according to Example 1 of an embodiment of the invention;
Fig. 2 is a cross-sectional view illustrating the detailed lens structure of the stacked type camera module according to Example 1;
Fig. 3 is a diagram illustrating the MTF characteristics of the stacked type camera module according to Example 1;
Fig. 4 is a diagram illustrating the MTF characteristics of the stacked type camera module according to Example 1;
Fig. 5 is a diagram illustrating the MTF characteristics of the stacked type camera module according to Example 1;
Fig. 6 is a cross-sectional view illustrating a stacked type camera module according to Example 2;
Fig. 7 is a diagram illustrating the MTF characteristics of the stacked type camera module according to Example 2;
Fig. 8 is a diagram illustrating the MTF characteristics of the stacked type camera module according to Example 2;
Fig. 9 is a cross-sectional view illustrating a stacked type camera module according to Example 3;
Fig. 10 is a cross-sectional view illustrating the arrangement of four piezoelectric elements on a position adjusting substrate;
Fig. 11 is a cross-sectional view illustrating the arrangement of eight piezoelectric elements on the position adjusting substrate;
Fig. 12A is a diagram illustrating the MTF characteristics of the stacked type camera module according to Example 3;
Fig. 12B is a diagram illustrating the MTF characteristics of the stacked type camera module according to Example 3;
Fig. 12C is a diagram illustrating the MTF characteristics of the stacked type camera module according to Example 3;
Fig. 12D is a diagram illustrating the MTF characteristics of the stacked type camera module according to Example 3;
Fig. 13A is a diagram illustrating the MTF characteristics of the stacked type camera module according to Example 3;
Fig. 13B is a diagram illustrating the MTF characteristics of the stacked type camera module according to Example 3;
Fig. 13C is a diagram illustrating the MTF characteristics of the stacked type camera module according to Example 3;
Fig. 13D is a diagram illustrating the MTF characteristics of the stacked type camera module according to Example 3;
Fig. 14 is a cross-sectional view illustrating a stacked type camera module according to Example 4;
Fig. 15 is a cross-sectional view illustrating the arrangement of four piezoelectric elements on a position adjusting substrate;
Fig. 16 is a cross-sectional view illustrating the arrangement of eight piezoelectric elements on the position adjusting substrate;
Fig. 17 is a cross-sectional view illustrating a stacked type camera module according to Example 5;
Fig. 18 is a diagram illustrating the MTF characteristics of the stacked type camera module according to Example 5;
Fig. 19 is a diagram illustrating the MTF characteristics of the stacked type camera module according to Example 5;
Fig. 20 is a diagram illustrating the MTF characteristics of the stacked type camera module according to Example 5;
Fig. 21 is a cross-sectional view illustrating a stacked type camera module according to Example 6;
Fig. 22 is a diagram illustrating the MTF characteristics of the stacked type camera module according to Example 6;
Fig. 23 is a diagram illustrating the MTF characteristics of the stacked type camera module according to Example 6;
Fig. 24 is a cross-sectional view illustrating a stacked type camera module according to Example 7;
Fig. 25A is a diagram illustrating a process of a method of manufacturing the stacked type camera module according to the embodiment of the invention;
Fig. 25B is a diagram illustrating a process of the method of manufacturing the stacked type camera module according to the embodiment of the invention; and
Fig. 25C is a diagram illustrating a process of the method of manufacturing the stacked type camera module according to the embodiment of the invention.

### DESCRIPTION OF THE PREFERRED EMBODIMENTS

Hereinafter, exemplary embodiments of the invention will be described with reference to the accompanying drawings.

### <Example 1>

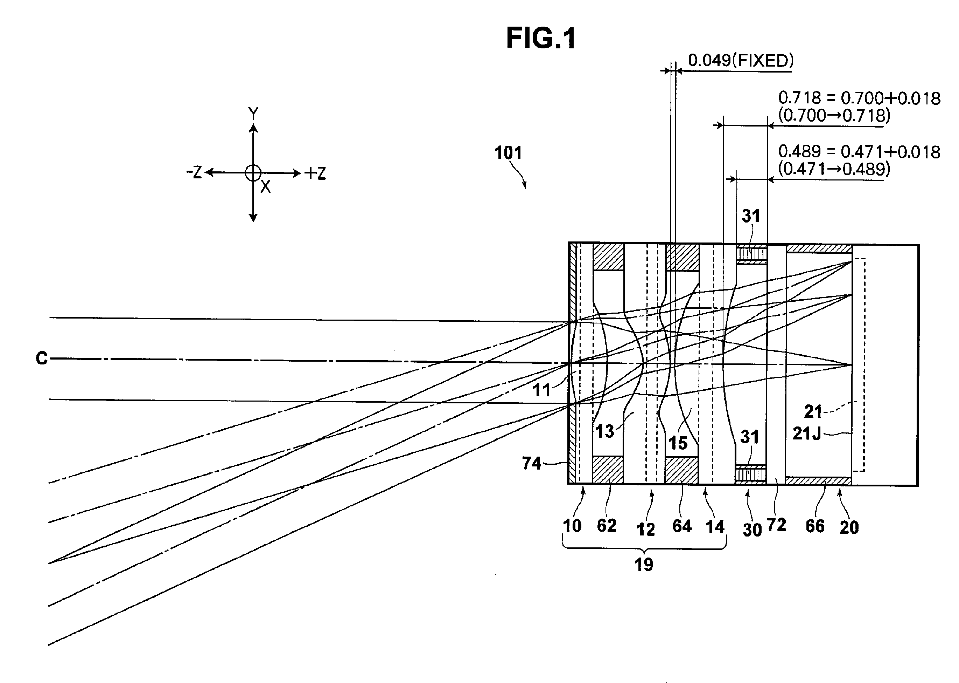

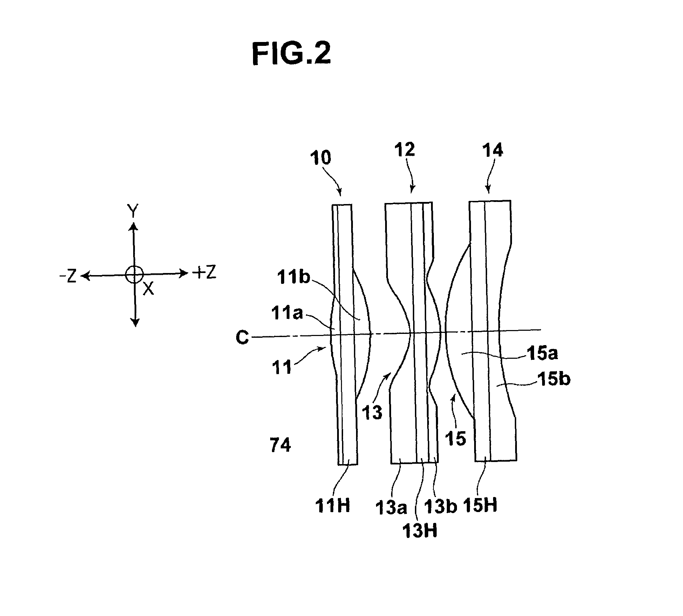

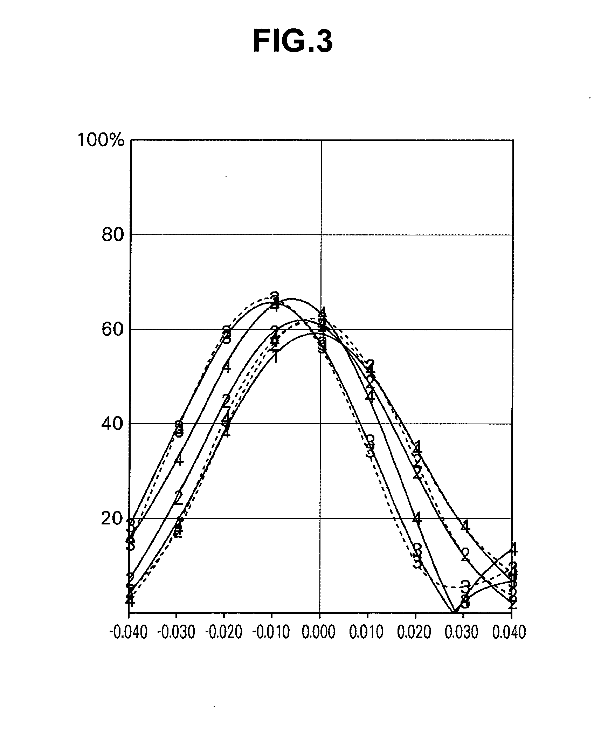

Fig. 1 is a cross-sectional view schematically illustrating the structure of a stacked type camera module according to Example 1 of an embodiment of the invention. Fig. 2 is a cross-sectional view illustrating the detailed lens structure of the stacked type camera module. Figs. 3, 4, and 5 are diagrams illustrating MTF characteristics of the stacked type camera module.

A stacked type camera module 101 according to Example 1 shown in Fig. 1 includes first to third lens substrates 10, 12, and 14 on which a first lens 11, a second lens 13, and a third lens 15 are respectively provided, an imaging substrate 20 having an imaging device 21 including a light receiving surface 21J provided thereon, and a position adjusting substrate 30 having a piezoelectric element 31 for adjusting the positional relationship between the third lens substrate 14 and the imaging substrate 20 adjacent to each other provided thereon.

The stacked type camera module 101 is formed by stacking substrates, that is, the first lens substrate 10, the second lens substrate 12, the third lens substrate 14, the position adjusting substrate 30, and the imaging substrate 20 in this order from an object side such that the imaging device 21 can capture an optical image of an object formed on the light receiving surface 21J through the first lens 11, the second lens 13, and the third lens 15.

The stacked type camera module 101 further includes an infrared cut filter 72, which is a plane parallel plate provided between the imaging substrate 20 and the position adjusting substrate 30, and an aperture diaphragm 74 that is provided on the object side of the first lens 11. The infrared cut filter 72 prevents infrared light that can be detected by the imaging device 21 but is not necessary to capture the image of an object from being incident on the light receiving surface 21J.

A spacer 62 is provided between the lens substrate 10 and the lens substrate 12. A spacer 64 is provided between the lens substrate 12 and the lens substrate 14. The position adjusting substrate 30 is provided between the lens substrate 14 and the infrared cut filter 72. A spacer 66 is provided between the infrared cut filter 72 and the imaging substrate 20. The spacers 62, 64, and 66, and the position adjusting substrate 30 are provided such that the first lens 11, the second lens 13, the third lens 15, and the light receiving surface 21J are disposed at predetermined positions, that is, with desired air spaces therebetween.

The first lens 11 formed on the lens substrate 10, the second lens 13 formed on the lens substrate 12, and the third lens 15 formed on the lens substrate 14 each have aspheric surfaces at both sides. As such, in the stacked type camera module 101, six aspheric surfaces are arranged on the rear side of the aperture diaphragm 74.

Specifically, as shown in Fig. 2, the first lens 11 formed on the lens substrate 10 is formed by adhering thermosetting resins 11a and 11b having heat resistance to both sides of a plane parallel plate 11H that is made of a glass material. The second lens 13 formed on the lens substrate 12 is formed by adhering thermosetting resins 13a and 13b having heat resistance to both sides of a plane parallel plate 13H that is made of a glass material. The third lens 15 formed on the lens substrate 14 is formed by adhering thermosetting resins 15a and 15b having heat resistance to both sides of a plane parallel plate 15H that is made of a glass material.

These lens substrates may be formed by methods disclosed in Japanese Patent No. 3976780, Japanese Patent No. 3976781, and Japanese Patent No. 3976782.

These lens substrates may be formed by a semiconductor manufacturing process. In addition, the entire stacked type camera module may be formed by the semiconductor manufacturing process.

The piezoelectric element 31 provided on the position adjusting substrate 30 moves the entire imaging lens 19 including the first lens 11, the second lens 13, and the third lens 15 relative to the imaging device 21 in the direction of an optical axis C (the Z direction in the drawings). In this way, it is possible to move the entire lens system to adjust focus.

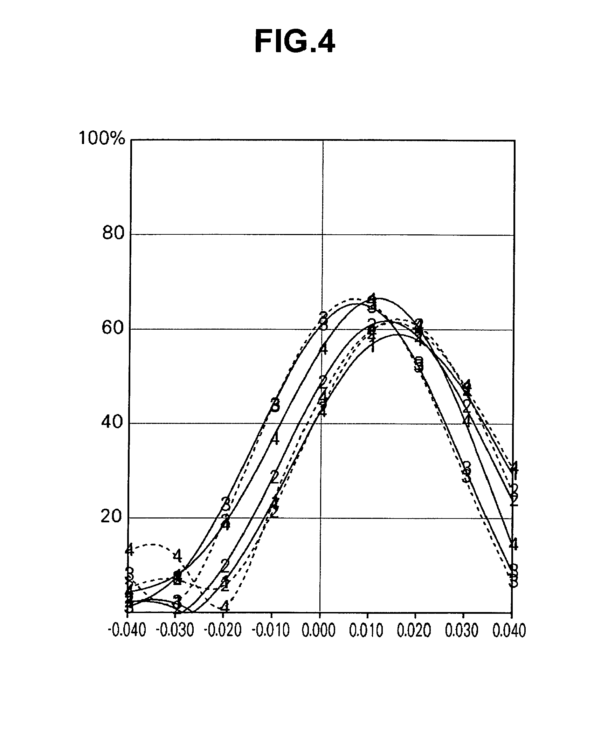

Fig. 3 is a graph illustrating the MTF characteristics of the stacked type camera module 101 at an optimal object distance (2.5 meters). Fig. 4 is a graph illustrating the MTF characteristics of the stacked type camera module 101 at a short object distance (0.5 meter). In the graphs, the peaks of the MTF characteristic curves deviate in the optical axis direction. The reason is that, when an object approaches the imaging lens 19, the optical image of the object formed through the imaging lens 19 is moved in the optical axis direction.

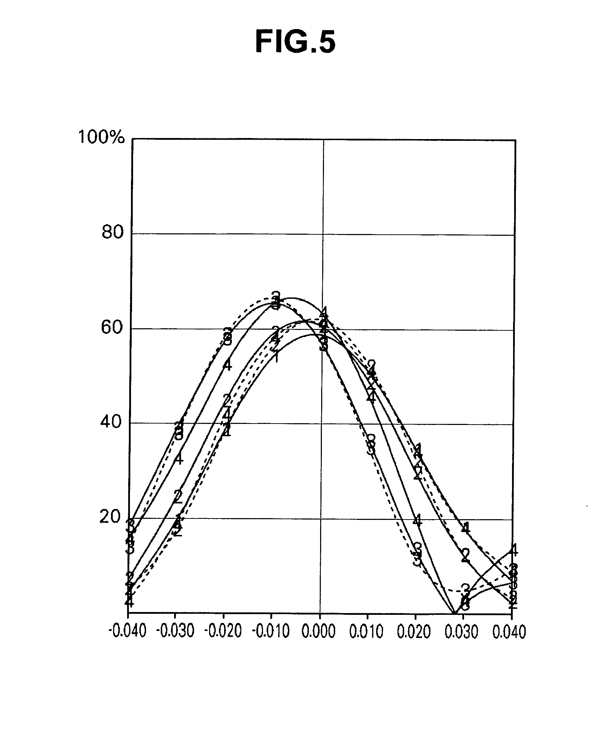

Fig. 5 is a graph illustrating the MTF characteristics when the piezoelectric element 31 formed on the position adjusting substrate 30 is driven to move the entire lens system for focusing. As can be seen from Fig. 5, the entire lens system is moved a distance for canceling the movement of the optical image (18 micrometers) to move the peak of the MTF characteristic curve to the same position as that where the MTF characteristic curve shown in Fig. 3 has a peak, thereby canceling the movement of a focal point due to a variation in object distance.

That is, the piezoelectric element 31 is driven to increase the thickness, serving as a spacer, of the position adjusting substrate 30 from 0.471 mm to 0.489 mm and increase the air space between the lens substrate 14 and the infrared cut filter 72 from 0.700 mm to 0.718 mm, thereby canceling a variation in the imaging position of an optical image due to a variation in object distance.

Figs. 3, 4, and 5 showing the MTF characteristics show MTF characteristic curves at 120 line pairs/mm, in which the unit of the horizontal axis is millimeter (mm) and the unit of the vertical axis is percentage (%). In addition, in Figs. 3, 4, and 5, reference numeral 1 indicates an MTF characteristic curve on the axis, reference numeral 2 indicates an MTF characteristic curve at an image height of 0.5 mm, reference numeral 3 indicates an MTF characteristic curve at an image height of 1.0 mm, and reference numeral 4 indicates an MTF characteristic curve at an image height of 1.5 mm. In Figs. 3, 4, and 5, solid lines indicate the MTF characteristics in a sagittal direction, and dashed lines indicate the MTF characteristics in a tangential direction. In addition, in Figs. 3, 4, and 5, a point on the horizontal axis represented by a value of 0.000 is an imaging position in terms of the design.

### <Example 2>

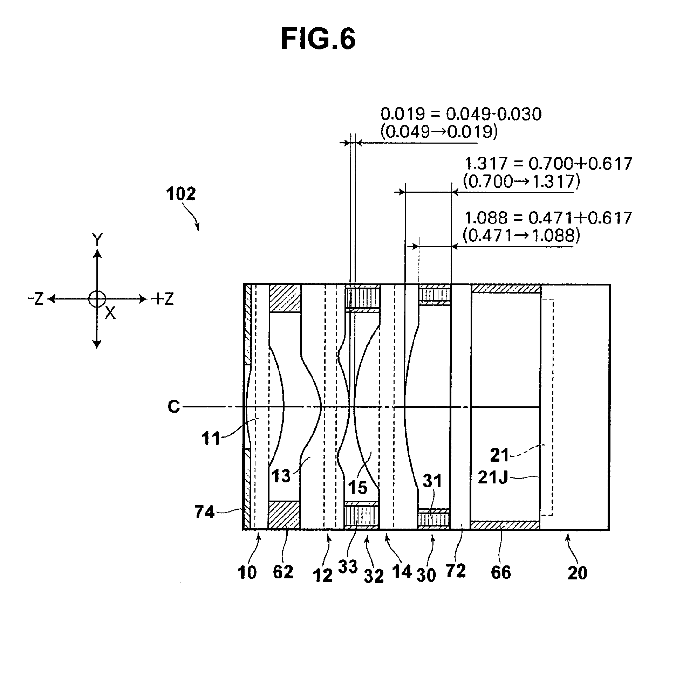

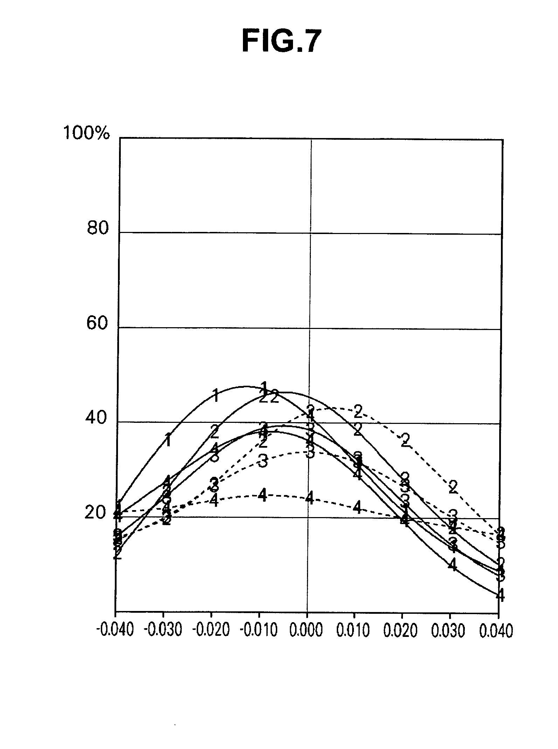

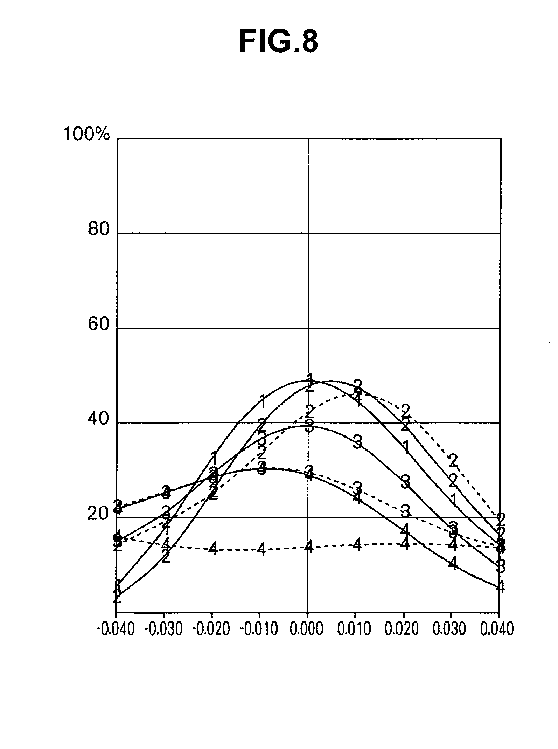

Fig. 6 is a cross-sectional view illustrating a stacked type camera module 102 according to Example 2, and Figs. 7 and 8 are diagrams illustrating the MTF characteristics of the stacked type camera module 102.

In the stacked type camera module 102, a position adjusting substrate 32 having a piezoelectric element 33 provided thereon replaces the spacer 64 in the stacked type camera module 101. The addition of the position adjusting substrate 32 makes it possible to adjust the positional relationship between the second lens substrate 12 and the third lens substrate 14 in the direction of the optical axis C (the Z direction in the drawings). In this way, it is possible to independently move the third lens 15. The other structures are the same as those of the stacked type camera module 101 according to Example 1. In Example 2, the same components as those in Example 1 are denoted by the same reference numerals, and a detailed description thereof will be omitted.

Fig. 7 is a graph illustrating the MTF characteristics at an object distance (2 centimeters) in a macro range which is shorter than that in near-distance photographing (0.5 meter), in the stacked type camera module 101 according to Example 1. In this case, the entire lens system is moved 644 micrometers for focusing by the driving of the piezoelectric element 31 of the position adjusting substrate 30.

As can be clearly seen from the MTF characteristics shown in Fig. 7, S and T image surfaces are broken, as compared to the MTF characteristics shown in Figs. 3 to 5. Therefore, the quality of an image obtained by a camera module under the above-mentioned imaging conditions is lowered. The stacked type camera module 102 according to Example 2 is for reducing the image deterioration.

The stacked type camera module 102 according to Example 2 does not completely prevent the S and T image surfaces from being broken, but can improve the performance of the center of a screen by driving the piezoelectric element 33 formed on the position adjusting substrate 32 to move the third lens to the object side by 30 micrometers, in addition to driving the piezoelectric element 31 formed on the position adjusting substrate 30 to move the entire lens system by 617 micrometers for focusing. In this way, it is possible to improve the situation that the S and T image surfaces are broken.

Fig. 8 shows MTF characteristic curves obtained by the improved stacked type camera module 102. As can be seen from the MTF characteristic curves shown in Fig. 8, the performance at the center and a second angel of view (see the MTF characteristic curve at an image height of 0.5 mm represented by reference numeral 2 in Fig. 8) is improved.

However, the degree of improvement, that is, the degree of correction of an angel of view depends on the optical design, and the degree of correction of an angel of view is not limited to this example.

Figs. 7 and 8 showing the MTF characteristics show MTF characteristic curves at 120 line pairs/mm, in which the unit of the horizontal axis is millimeter (mm) and the unit of the vertical axis is percentage (%). In addition, in Figs. 7 and 8, reference numeral 1 indicates an MTF characteristic curve on the axis, reference numeral 2 indicates an MTF characteristic curve at an image height of 0.5 mm, reference numeral 3 indicates an MTF characteristic curve at an image height of 1.0 mm, and reference numeral 4 indicates an MTF characteristic curve at an image height of 1.5 mm. In Figs. 7 and 8, solid lines indicate the MTF characteristics in the sagittal direction, and dashed lines indicate the MTF characteristics in the tangential direction. In addition, in Figs. 7 and 8, a point on the horizontal axis represented by a value of 0.000 is an imaging position in terms of the design.

### <Example 3>

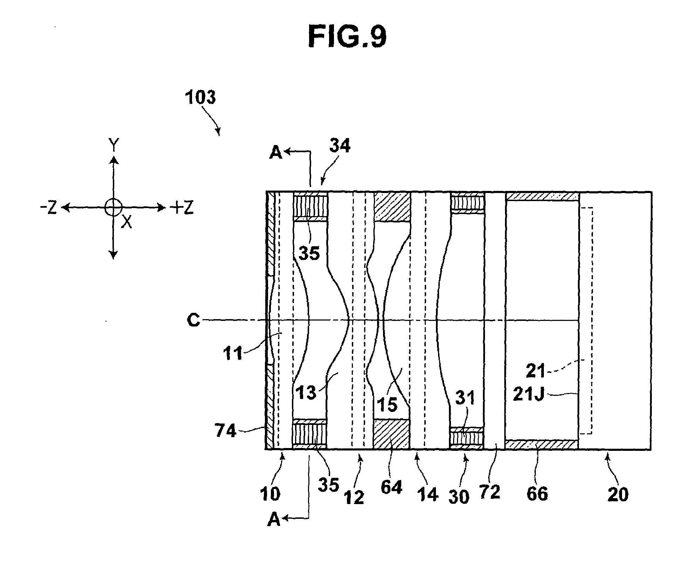

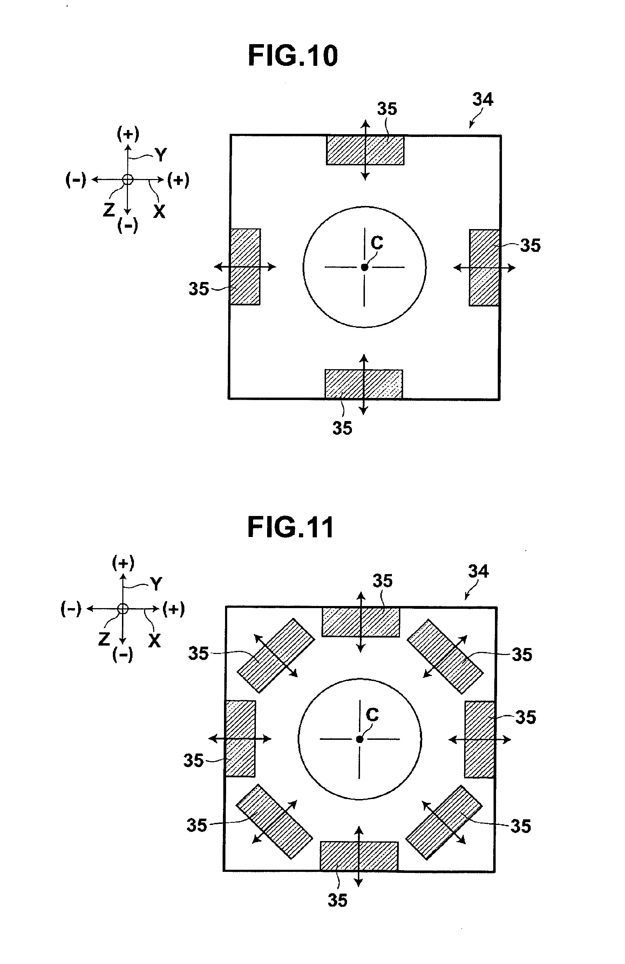

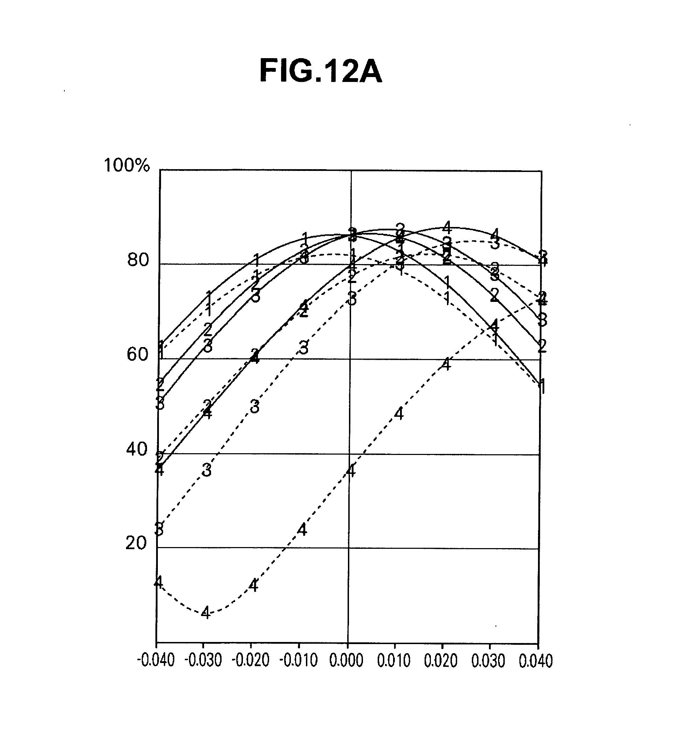

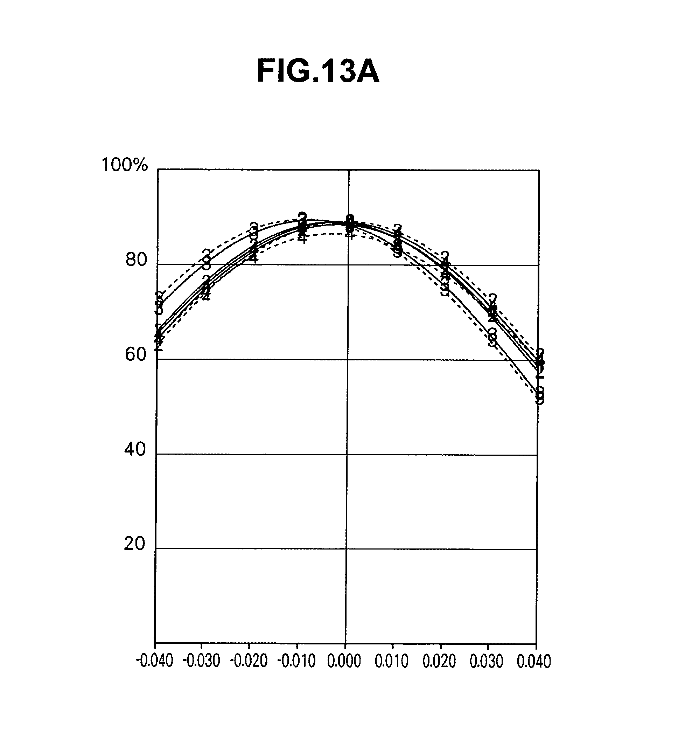

Fig. 9 is a cross-sectional view illustrating a stacked type camera module 103 according to Example 3, and Figs. 10 and 11 are cross-sectional views illustrating the arrangement of piezoelectric elements on a position adjusting substrate. Figs. 12A to 12D and Figs. 13A to 13D are diagrams illustrating the MTF characteristics of the stacked type camera module 103.

In the stacked type camera module 103 according to Example 3, a position adjusting substrate 34 having piezoelectric elements 35 provided thereon replaces the spacer 62 in the stacked type camera module 101 according to Example 1, and can move the first lens 11 relative to the second lens 13 in a direction orthogonal to the optical axis C (in an X-Y plane direction in the drawings). The other structures are the same as those in the stacked type camera module 101 according to Example 1. In Example 3, the same components as those in Example 1 are denoted by the same reference numerals, and a detailed description thereof will be omitted.

Fig. 10 is a cross-sectional view illustrating the position adjusting substrate 34 having four piezoelectric elements provided thereon taken along the line A-A of Fig. 9 in the direction orthogonal to the optical axis, and Fig. 11 is a cross-sectional view illustrating the position adjusting substrate 34 having eight piezoelectric elements provided thereon taken along the line A-A of Fig. 9 in the direction orthogonal to the optical axis.

An actuator composed of the piezoelectric elements is arranged outside an optical path having a cylindrical shape that extends in a direction in which the substrates for transmitting the optical image of an object to a light receiving surface are stacked.

As shown in Fig. 10, four piezoelectric elements 35 are provided on the position adjusting substrate 34 at positions in the directions of arrows +X, -X, +Y, and -Y, and move the first lens 11 in an arbitrary direction in the plane orthogonal to the optical axis (the direction extending in the X-Y plane of Fig. 10). Fig. 11 shows the arrangement of the piezoelectric elements in which four piezoelectric elements 35 are additionally provided at positions that are inclined at an angle of 45 degrees with respect to the directions of the arrows +X, -X, +Y, and -Y. The arrangement of the piezoelectric elements can improve the accuracy of moving the first lens 11.

However, the invention is not limited to the structure in which the piezoelectric elements are provided on the position adjusting substrate 34. Essentially, the position adjusting substrate 34 may be configured such that it moves the first lens 11 provided on the first lens substrate 10, or a specific lens in the direction orthogonal to the optical axis to correct shake when an optical image is formed on the light receiving surface 21.

In the stacked type camera module 103, when the first lens 11 is moved 10 micrometers in the direction orthogonal to the optical axis, it is possible to correct a shake of 0.2 degree by the operation of a convex lens.

The focal length of the lens system of the stacked type camera module 103 is 3.311 millimeters (f = 3.311), and when a shake of 0.2 degree (θ = 0.2 degree) occurs, a blur amount δ (= f x tan(θ)) is 12 micrometers (3.311 x tan(0.2)).

12 micrometers correspond to 42 line pairs/mm as a spatial frequency. When a shake of 0.2 degree occurs during image capture, ideally, a point image is extended 12 micrometers in a direction in which shake occurs. In this case, it is difficult to define resolution at a spatial frequency that is higher than a frequency corresponding to 42 line pairs/mm. That is, image quality is too low to discuss MTF.

Figs. 12A to 12D show MTF characteristic curves when the first lens 11 is moved 10 micrometers in the direction orthogonal to the optical axis in order to correct a shake of 0.2 degree in the lens system according to Example 3. As can be clearly seen from Figs. 12A to 12D, a certain degree of MTF is maintained. Figs. 13A to 13D show characteristic curves when the first lens 11 is not moved (when all the lenses are ideally arranged on the optical axis). In the MTF characteristics shown in Figs. 12A to 12D, the performance is lower than that in the MTF characteristics shown in Figs. 13A to 13D, but is better than that in the structure in which correction is not performed and it is difficult to define the resolution at a spatial frequency that is higher than a frequency corresponding to 42 line pairs/mm.

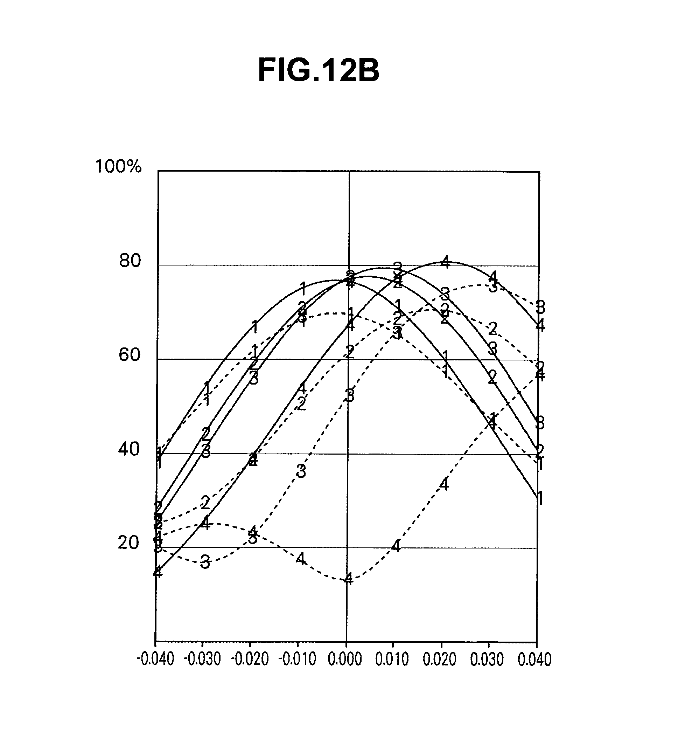

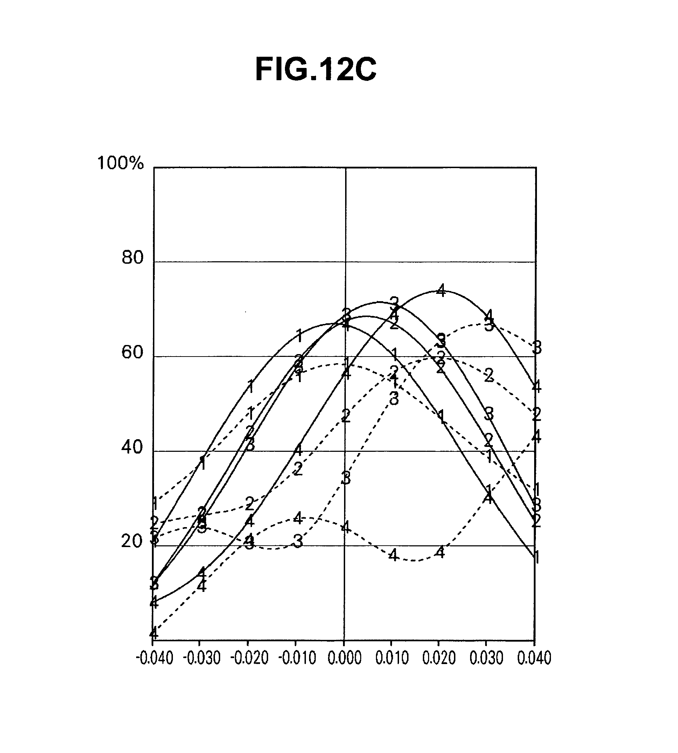

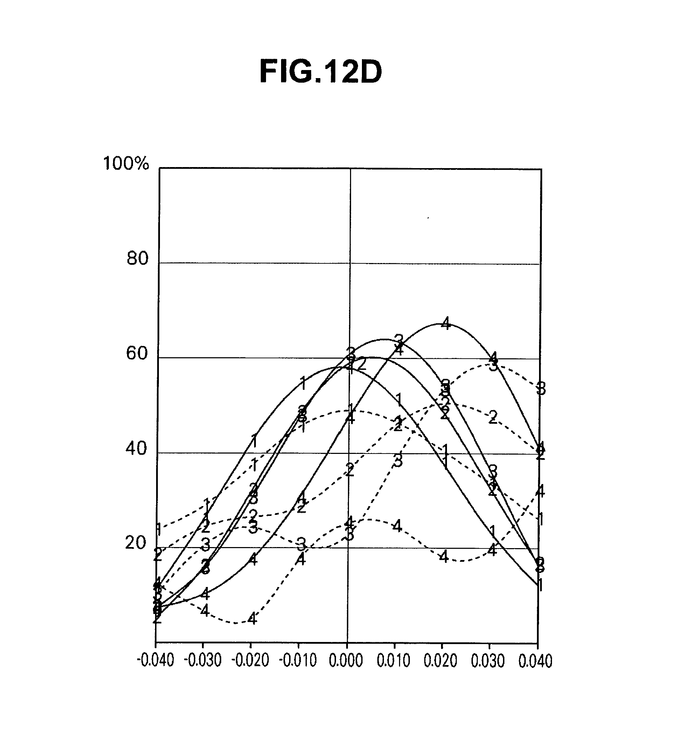

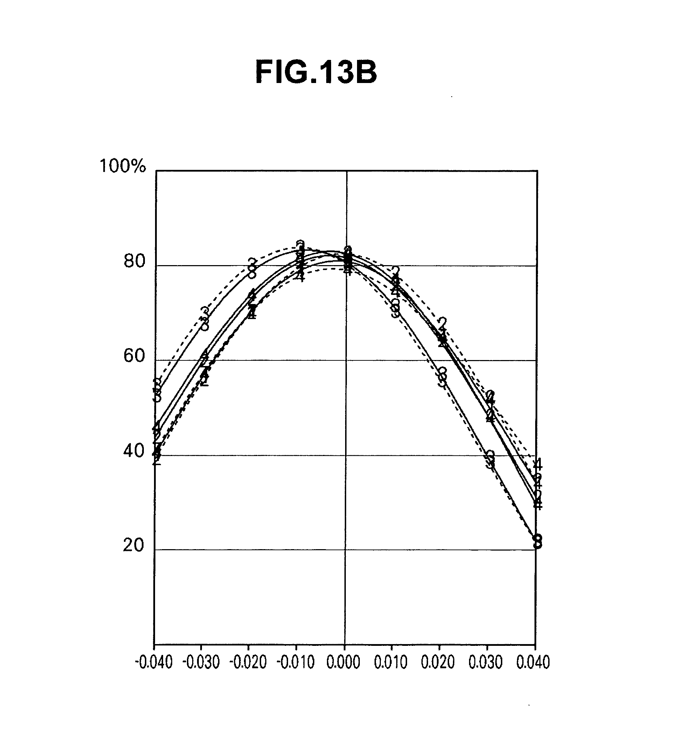

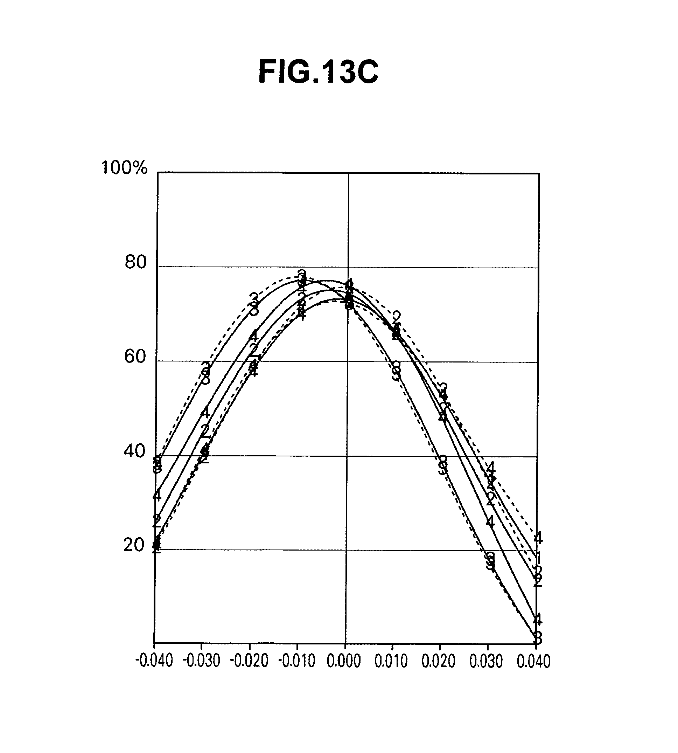

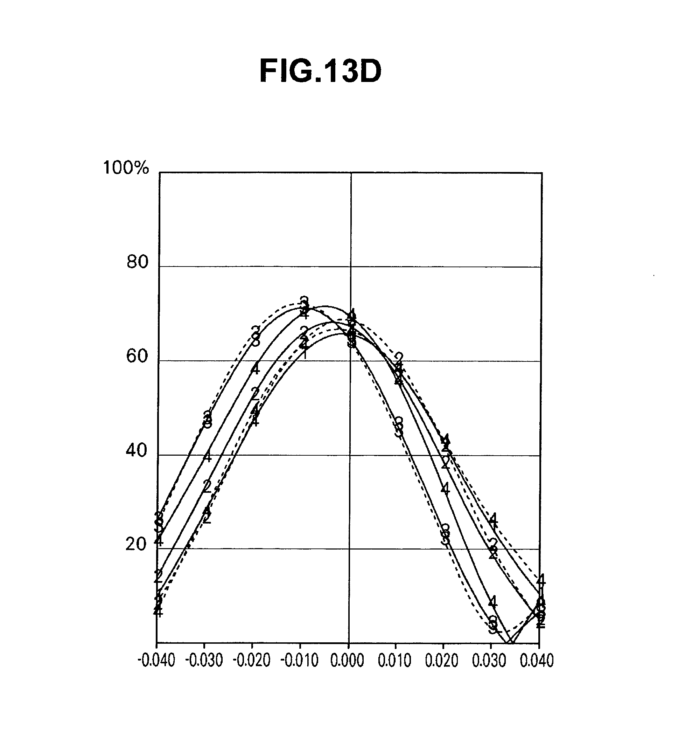

Figs. 12A and 13A show MTF characteristic curves at 40 line pairs/mm, Figs. 12B and 13B show MTF characteristic curves at 60 line pairs/mm, Figs. 12C and 13C show MTF characteristic curves at 80 line pairs/mm, and Figs. 12D and 13D show MTF characteristic curves at 100 line pairs/mm, in which the unit of the horizontal axis is millimeter (mm) and the unit of the vertical axis is percentage (%). In addition, in Figs. 12A to 12D and Figs. 13A to 13D, reference numeral 1 indicates an MTF characteristic curve on the axis, reference numeral 2 indicates an MTF characteristic curve at an image height of 0.5 mm, reference numeral 3 indicates an MTF characteristic curve at an image height of 1.0 mm, and reference numeral 4 indicates an MTF characteristic curve at an image height of 1.5 mm. In Figs. 12A to 12D and Figs. 13A to 13D, solid lines indicate the MTF characteristics in the sagittal direction, and dashed lines indicate the MTF characteristics in the tangential direction. In addition, in Figs. 12A to 12D and Figs. 13A to 13D, a point on the horizontal axis represented by a value of 0.000 is an imaging position in terms of the design.

### <Example 4>

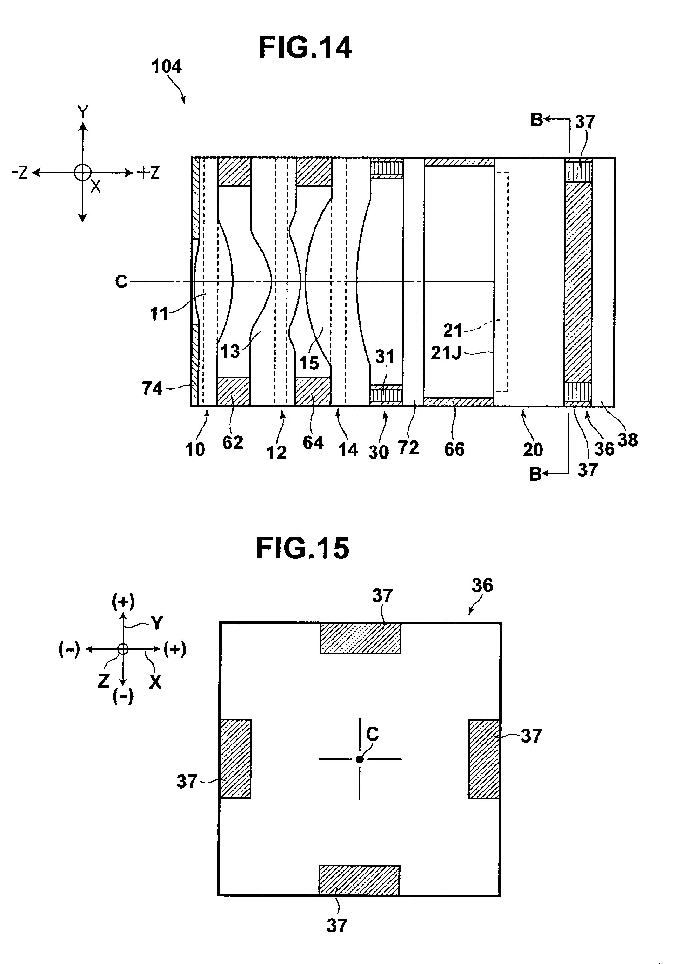

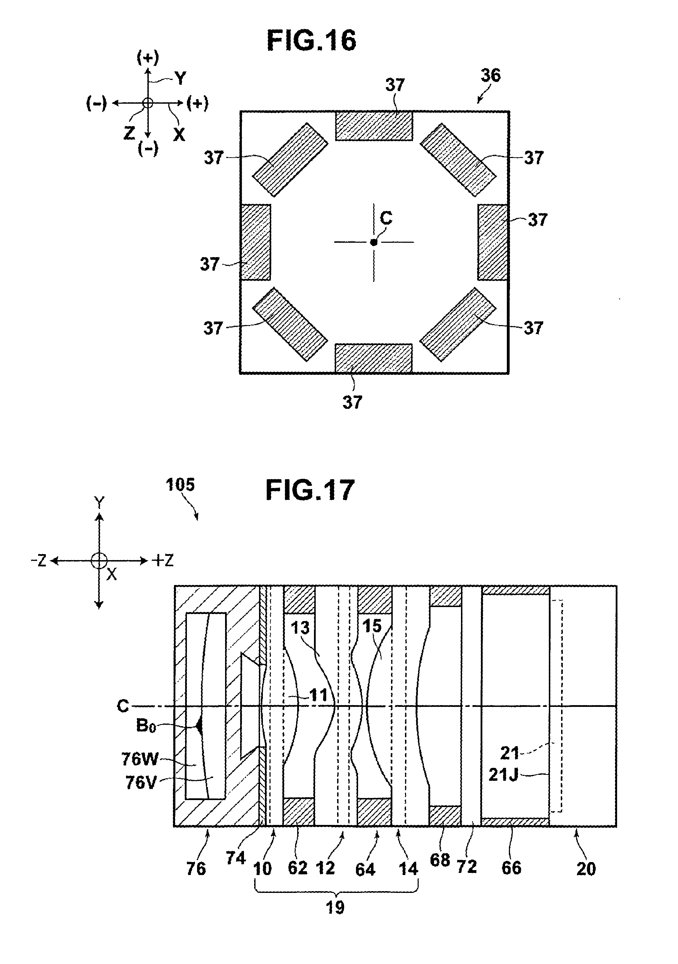

Fig. 14 is a cross-sectional view illustrating a stacked type camera module 104 according to Example 4, and Figs. 15 and 16 are cross-sectional views illustrating the arrangement of piezoelectric elements on a position adjusting substrate.

In the stacked type camera module 104, a position adjusting substrate 36 having piezoelectric elements 37 provided thereon and a base substrate 38 supporting the position adjusting substrate 36 are arranged in this order on the image side of the imaging substrate 20 of the stacked type camera module 101 according to Example 1, and an imaging unit (that is, a portion having the same structure as that in the stacked type camera module 101) including a lens system and an imaging system can be integrally moved relative to the base substrate 38. The other structures are the same as those in the stacked type camera module 101 according to Example 1. In Example 4, the same components as those in Example 1 are denoted by the same reference numerals, and a detailed description thereof will be omitted.

Fig. 15 is a cross-sectional view illustrating the position adjusting substrate 36 having four piezoelectric elements 37 provided thereon taken along the line B-B of Fig. 14 in the direction orthogonal to the optical axis, and Fig. 16 is a cross-sectional view illustrating the position adjusting substrate 36 having eight piezoelectric elements provided thereon taken along the line B-B of Fig. 14 in the direction orthogonal to the optical axis.

As shown in Fig. 15, four piezoelectric elements 37 are provided on the position adjusting substrate 36 at positions in the directions of arrows +X, -X, +Y, and -Y, and are individually expanded or contracted in the optical axis direction to integrally incline the lens system and the imaging system. In this way, it is possible to integrally incline the lens system and the imaging system in an arbitrary direction. Fig. 16 shows the arrangement of the piezoelectric elements in which four piezoelectric elements 37 are additionally provided at positions that are inclined at an angle of 45 degrees with respect to the directions of the arrows +X, -X, +Y, and -Y. The arrangement of the piezoelectric elements can improve driving accuracy.

The arrangement of the piezoelectric elements is similar to that according to Example 3 shown in Figs. 10 and 11 except that a movement direction is the direction of the optical axis C (the Z direction in the drawings). It is necessary to integrally displace the lens system and the imaging system in the pitch direction and the yaw direction in order to correct shake. Therefore, the piezoelectric elements 37 are individually driven in the optical axis direction to displace the lens system and the imaging system in the pitch direction and the yaw direction.

As such, it is most preferable to integrally move the lens system and a light receiving element in order to correct shake. This is because a relative positional relationship does not vary in an imaging optical system including the lens system and the imaging system. In particular, the pitch between the pixels of an imaging device is generally 1.75 micrometers, which is a very small value, or the position accuracy of each lens in an optical system having a small F number is generally about 10 micrometers. An eccentricity of 10 micrometers of the lens shown in Example 3 is for correction, but is not preferable to maintain an optical performance. Therefore, it is more preferable to integrally move the lens system and the imaging system to correct shake, as in Example 4.

However, in the stacked type camera module 104, since the positional relationships among the first lens 11, the second lens 13, the third lens 15, and the light receiving surface 21J do not vary during shake correction, it is possible to maintain the MTF characteristics shown in Fig. 13, that is, the designed performance.

### <Example 5>

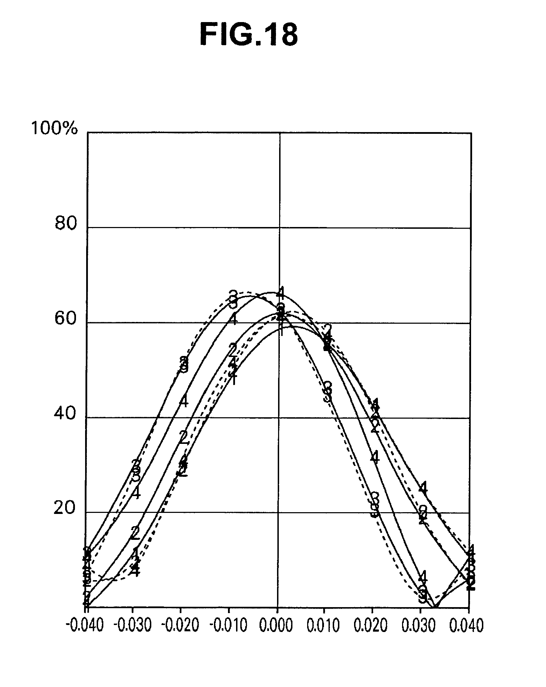

Fig. 17 is a cross-sectional view illustrating a stacked type camera module 105 according to Example 5, and Figs. 18, 19, and 20 are diagrams illustrating the MTF characteristics of the stacked type camera module 105.

In the stacked type camera module 105, a liquid lens substrate 76 having a liquid lens provided thereon is arranged in front of the stacked type camera module 101 according to Example 1 (on the object side of the first lens 11) and a simple spacer 68 replaces the position adjusting substrate 30 provided between the third lens 14 and the infrared cut filter 72 in the stacked type camera module 101 according to Example 1. In this way, it is possible to achieve a performance substantially similar to focus adjustment by moving the entire lens system, without any movable portion. The other structures are the same as those in the stacked type camera module 101 according to Example 1. In Example 5, the same components as those in Example 1 are denoted by the same reference numerals, and a detailed description thereof will be omitted.

The liquid lens has been well known, and can adjust lens characteristics by deforming a curved interface between water 76W and oil 76V contained in the liquid lens.

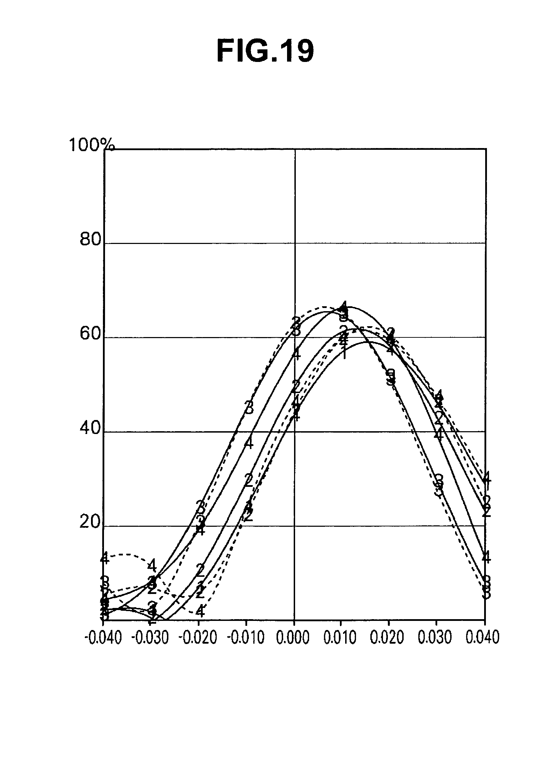

Fig. 18 is a graph illustrating the MTF characteristics of the stacked type camera module 105 at an optimal object distance (2.5 meters). Fig. 19 is a graph illustrating the MTF characteristics of the stacked type camera module 105 at a short object distance (0.64 meter). As shown in Fig. 19, the peaks of the MTF characteristic curves deviate in the optical axis direction (the Z direction of Fig. 19). The reason is that, when an object approaches the stacked type camera module 105, an optical image formed on the light receiving surface is moved a distance corresponding thereto in the optical axis direction.

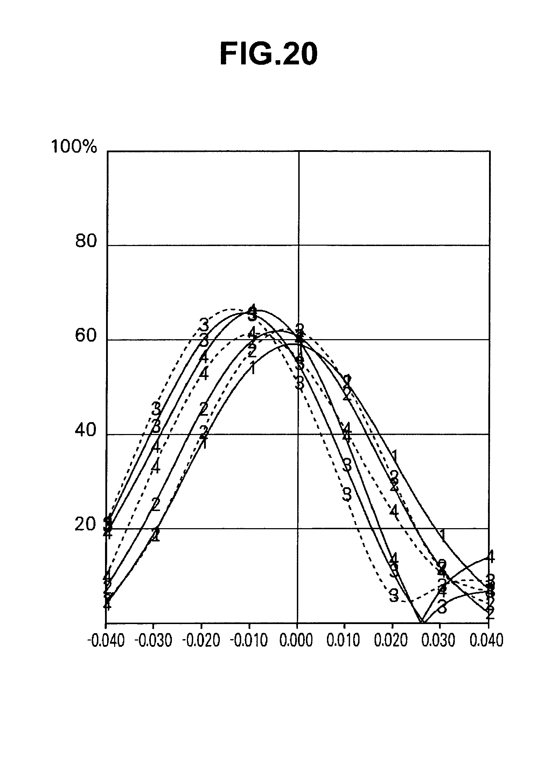

Fig. 20 is a diagram illustrating MTF characteristics when the liquid lens provided on the liquid lens substrate 76 is driven to control an interface Bo between the water 76W and the oil 76V to have a curvature radius of 90 millimeters (a convex surface faces the object side). As can be seen from Fig. 20, the peak of the MTF characteristics is disposed at the same position as that where the MTF characteristic curve has a peak at the optimal object distance (2.5 meters) shown in Fig. 18, and it is possible to cancel the movement of a focus position due to a variation in object distance only by adjusting the liquid lens.

Figs. 18 to 20 showing the MTF characteristics show MTF characteristic curves at 120 line pairs/mm, in which the unit of the horizontal axis is millimeter (mm) and the unit of the vertical axis is percentage (%). In addition, in Figs. 18 to 20, reference numeral 1 indicates an MTF characteristic curve on the axis, reference numeral 2 indicates an MTF characteristic curve at an image height of 0.5 mm, reference numeral 3 indicates an MTF characteristic curve at an image height of 1.0 mm, and reference numeral 4 indicates an MTF characteristic curve at an image height of 1.5 mm. In Figs. 18 to 20, solid lines indicate the MTF characteristics in the sagittal direction, and dashed lines indicate the MTF characteristics in the tangential direction. In addition, in Figs. 18 to 20, a point on the horizontal axis represented by a value of 0.000 is an imaging position in terms of the design.

### <Example 6>

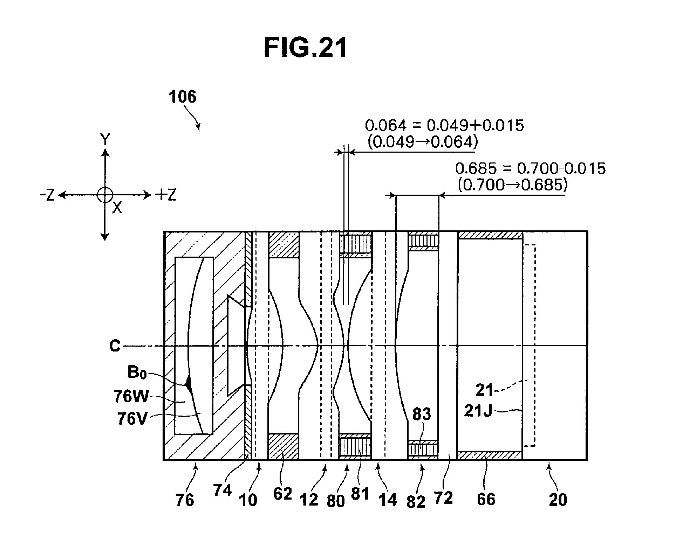

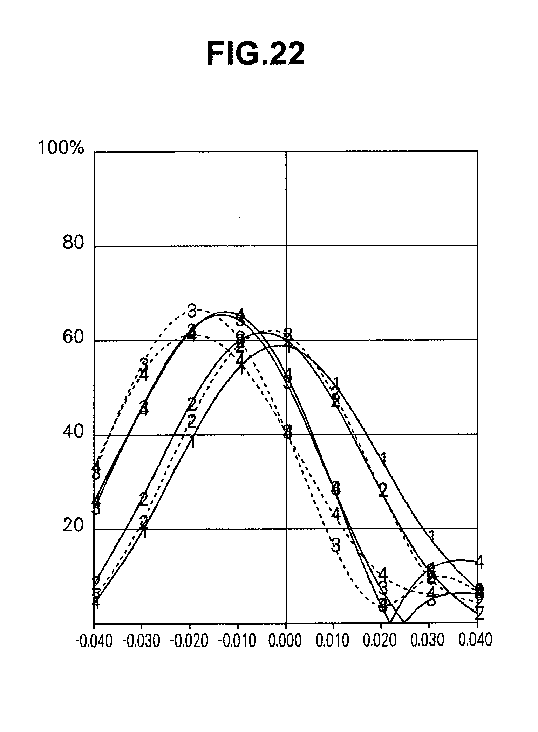

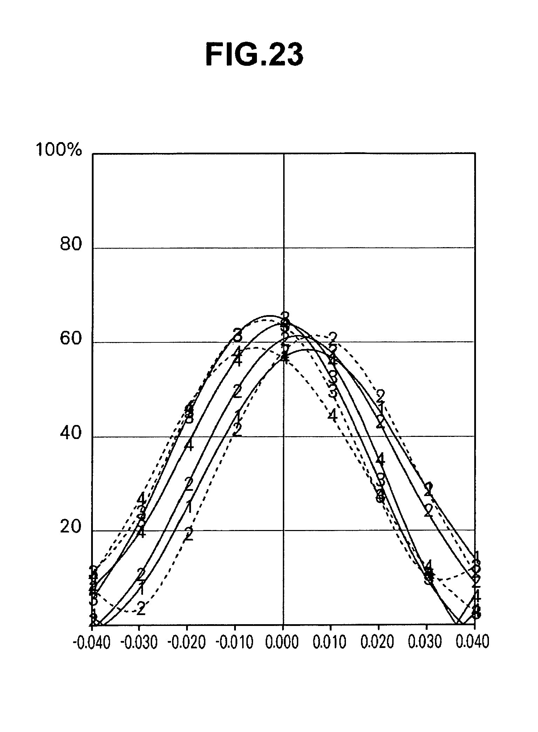

Fig. 21 is a cross-sectional view illustrating a stacked type camera module 106 according to Example 6, and Figs. 22 and 23 are diagrams illustrating the MTF characteristics of the stacked type camera module 106.

The stacked type camera module 106 is a modification of the stacked type camera module 105 according to Example 5 shown in Fig. 17. In the stacked type camera module 106 , a position adjusting substrate 80 having piezoelectric elements 81 provided thereon replaces the spacer 64 between the second lens 12 and the third lens 14, and a position adjusting substrate 82 having piezoelectric elements 83 provided thereon replaces the spacer 68 between the third lens 14 and the infrared cut filter 72. In this way, the third lens 14 is independently moved.
The other structures are the same as those in the stacked type camera module 105 according to Example 5. In Example 6, the same components as those in Example 5 are denoted by the same reference numerals, and a detailed description thereof will be omitted.

Fig. 22 is a graph illustrating MTF characteristic curves at an object distance (0.25 meter) in a macro range which is shorter than that in near-distance photographing (0.64 meter), in the stacked type camera module 106 according to Example 6. In this case, the liquid lens is controlled such that the curvature radius of the interface Bo is 35 millimeters.

As can be clearly seen from the MTF characteristic curves shown in Fig. 22, S and T image surfaces are broken, as compared to the MTF characteristic curves according to Example 5 shown in Figs. 19 and 20. Therefore, the quality of an image obtained by the camera module is lowered. It is difficult to completely remove this situation, but it is possible to improve the overall lens performance by moving the third lens 14 to the image side (to the light receiving surface 21J) by 15 micrometers, in addition to controlling the liquid lens such that the curvature radius of the interface Bo is 35 millimeters.

In this case, when only the third lens 14 is moved 15 micrometers to the image side, the length of the piezoelectric element 81 is increased 15 micrometers, but the length of the piezoelectric element 83 is decreased 15 micrometers. In this way, it is possible to move only the position of the third lens 14 in the stacked type camera module 106. Fig. 23 is a diagram illustrating MTF characteristics when the overall lens performance is improved.

However, the degree of improvement, that is, the degree of correction of an angel of view depends on the optical design, and the degree of correction of an angel of view is not limited to this example.

Figs. 22 and 23 showing the MTF characteristics show MTF characteristic curves at 120 line pairs/mm, in which the unit of the horizontal axis is millimeter (mm) and the unit of the vertical axis is percentage (%). In addition, in Figs. 22 and 23, reference numeral 1 indicates an MTF characteristic curve on the axis, reference numeral 2 indicates an MTF characteristic curve at an image height of 0.5 mm, reference numeral 3 indicates an MTF characteristic curve at an image height of 1.0 mm, and reference numeral 4 indicates an MTF characteristic curve at an image height of 1.5 mm. In Figs. 22 and 23, solid lines indicate the MTF characteristics in the sagittal direction, and dashed lines indicate the MTF characteristics in the tangential direction. In addition, in Figs. 22 and 23, a point on the horizontal axis represented by a value of 0.000 is an imaging position in terms of the design.

### <Example 7>

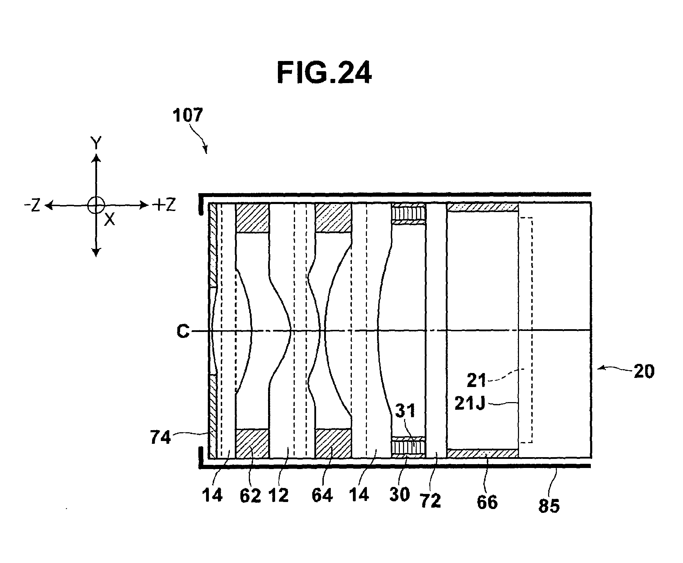

Fig. 24 is a cross-sectional view illustrating a stacked type camera module 107 according to Example 7.

The stacked type camera module 107 is configured by providing a light shielding portion 85 on the side surface of the stacked type camera module 101 according to Example 1. The light shielding portion 85 is formed by performing a light shielding process or arranging a light shielding member. The other structures are the same as those in the stacked type camera module 101 according to Example 1. In Example 7, the same components as those in Example 1 are denoted by the same reference numerals, and a detailed description thereof will be omitted.

The stacked type camera module 107 including the light shielding portion 85 can prevent stray light, which is noise, from being incident. Therefore, it is possible to further improve image quality.

As described above, the stacked type camera module according to the above-described embodiment of the invention includes the position adjusting substrate having the actuator provided thereon. Therefore, it is possible to adjust focus to accurately form the optical image of an object on the light receiving surface of an imaging device. In addition, since the position adjusting substrate has a stacked structure similar to other lens substrates, it is possible to easily assemble an imaging apparatus. Therefore, it is possible to improve image quality while preventing an increase in the size of an imaging apparatus or a reduction in productivity.

The stacked type camera module according to the invention is not limited to the above-described embodiment, but it can be modified and changed in various ways.

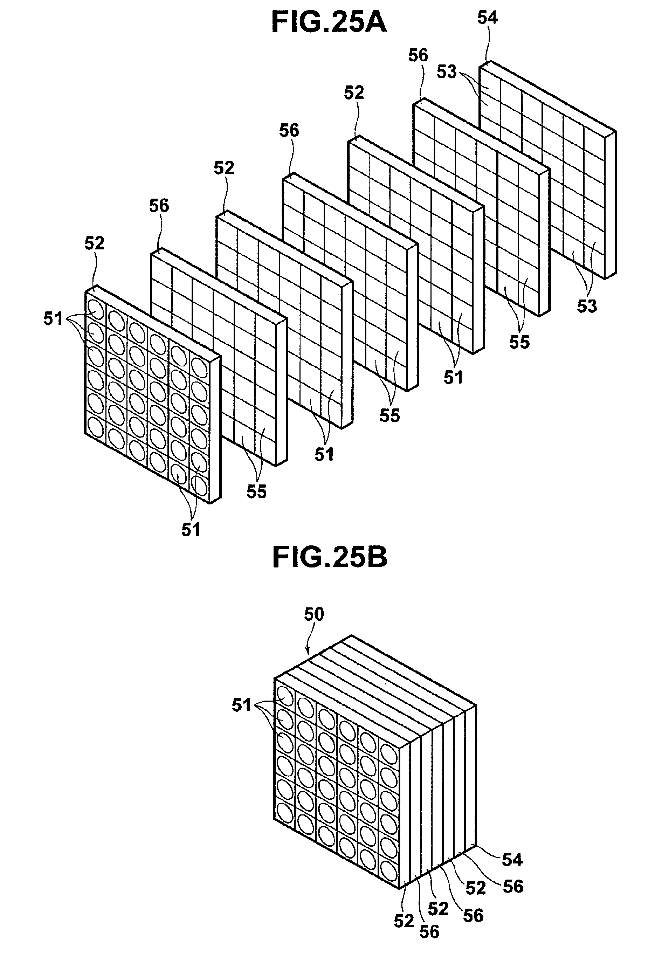

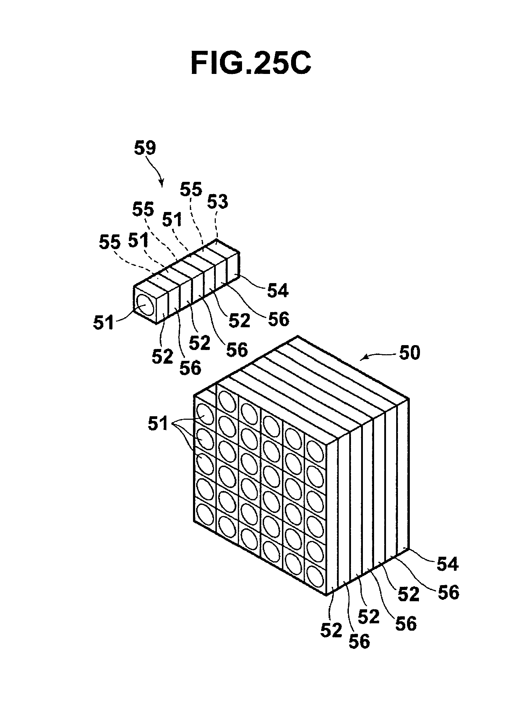

The above-mentioned stacked type camera module can be manufactured as follows. Figs. 25A, 25B, and 25C are diagrams illustrating a method of manufacturing the stacked type camera module according to the above-described embodiment of the invention.

In the method of manufacturing the stacked type camera module according to the above-described embodiment of the invention, as shown in Fig. 25A, three lens substrates 52, each of which is divided into a plurality of predetermined regions, that is, 36 (6x6) predetermined regions and includes lenses 51 provided in the divided regions, are prepared. In addition, an imaging substrate 54 including imaging devices 53, each having a light receiving surface, provided at positions corresponding to the 36 (6x6) predetermined regions is prepared.

In addition, three position adjusting substrates 56, each including actuators 55 that adjust the positional relationship between adjacent substrates and are provided at positions corresponding to the 36 (6x6) predetermined regions, are prepared.

Then, the 36 (6x6) predetermined regions are stacked such that the optical image of an object is formed on the light receiving surface of the imaging device 53 through the three lenses 51, thereby obtaining a stacked structure 50 shown in Fig. 25B.

Then, as shown in Fig. 25C, the stacked structure 50 is cut into 36 parts corresponding to the 36 predetermined regions along a plane of the stacked structure 50 orthogonal to the direction in which the substrates are stacked, thereby obtaining 36 stacked type camera modules 59 each having the imaging device 53 capable of capturing the optical image formed on the light receiving surface.

The term 'between adjacent substrates' means between the lens substrate 52 and the imaging substrate 54 or between two adjacent lens substrates 52 among a plurality of lens substrates 52.

The lens of the stacked type camera module has aspheric surfaces at both sides, but the invention is not limited thereto. For example, the lens may have spherical surfaces at both sides or it may have one spherical surface and the other aspheric surface. In addition, any type of lens may be used for the stacked type camera module as long as it has a lens effect.

In addition, the stacked type camera module may be used as a camera provided in, for example, a mobile phone, an in-vehicle camera, and an endoscope.

That is, the stacked type camera module may have contact points for reflow mounting. In this case, the stacked type camera module can be mounted to a printed circuit board by a reflow mounting method to manufacture, for example, a mobile phone, an in-vehicle camera, and an endoscope.

## Claims

1. A method of manufacturing a stacked type camera module, comprising:
stacking one or more lens substrates, each having lenses provided in a plurality of predetermined regions, an imaging substrate having imaging devices, each having a light receiving surface, provided at positions corresponding to the regions, and one or more position adjusting substrates having actuators that adjust the positional relationship between the substrates and are provided at positions corresponding to the regions, such that an optical image of an object is formed on the light receiving surfaces through the lenses; and
cutting the stacked structure into parts corresponding to the regions along a plane of the stacked structure that is orthogonal to a direction in which the substrates are stacked, thereby obtaining a plurality of stacked type camera modules each having the imaging device capable of capturing the optical image formed on the light receiving surface.

2. A stacked type camera module comprising:
one or more lens substrates having lenses provided thereon;
an imaging substrate having an imaging device with a light receiving surface provided thereon; and
one or more position adjusting substrates having actuators for adjusting the positional relationship between the substrates provided thereon,
wherein the substrates are stacked such that an optical image of an object is formed on the light receiving surface of the imaging device through the lenses.

3. The stacked type camera module according to claim 2,
wherein the position adjusting substrate adjusts the positional relationship between adjacent substrates in a direction in which the substrates are stacked.

4. The stacked type camera module according to claim 2 or 3,
wherein the position adjusting substrate adjusts the positional relationship between adjacent substrates in a direction orthogonal to the direction in which the substrates are stacked.

5. The stacked type camera module according to any one of claims 2 to 4,
wherein the position adjusting substrate adjusts the inclination between adjacent substrates.

6. The stacked type camera module according to any one of claims 2 to 5,
wherein two or more lens substrates are provided, and
the position adjusting substrates are provided both between the imaging substrate and the lens substrate adjacent to each other and between adjacent lens substrates.

7. The stacked type camera module according to any one of claims 2 to 6, further comprising:
a base substrate that is provided on one side of the imaging substrate opposite to the lens substrate; and
a base position adjusting substrate which is provided between the base substrate and the imaging substrate and on which an actuator for adjusting the positional relationship between the substrates in a direction orthogonal to the direction in which the substrates are stacked is provided.

8. The stacked type camera module according to any one of claims 2 to 7,
wherein the actuator is a piezoelectric element.

9. The stacked type camera module according to any one of claims 2 to 8,
wherein the actuator is arranged outside an optical path having a cylindrical shape that extends in the direction in which the substrates for transmitting the optical image of the object to the light receiving surface are stacked.

10. An imaging apparatus comprising the stacked type camera module according to any one of claims 2 to 9.
